# EUROPEAN PATENT SPECIFICATION

(11) **EP 2 993 687 B1**
(45) Date of publication and mention of the grant of the patent: **05.02.2020**
(21) Application number: 15181146.0
(22) Date of filing: 14.08.2015
(51) Int. Cl.: H01L 21/02, H01L 21/768, C23C 16/40, C23C 16/455, H01L 21/3105

(54) **METHOD FOR PROVIDING PORE SEALING LAYER ON POROUS LOW DIELECTRIC CONSTANT FILMS**
VERFAHREN ZUR HERSTELLUNG EINER PORENVERSIEGELUNGSSCHICHT AUF PORÖSEN FILMEN MIT GERINGER DIELEKTRIZITÄTSKONSTANTE
PROCÉDÉ POUR FOURNIR UNE COUCHE DE SCELLEMENT DE PORES SUR DES FILMS POREUX À FAIBLE CONSTANTE DIÉLECTRIQUE

(30) Priority: 14.08.2014 US 201462037392 P; 07.08.2015 US 201514820982
(43) Date of publication of application: 09.03.2016
(73) Proprietor: Versum Materials US, LLC, Tempe, AZ 85284 (US)
(72) Inventor: LI, Jianheng, Emmaus, PA Pennsylvania 18049 (US); VRTIS, Raymond Nicholas, Orefield, PA Pennsylvania 18069 (US); RIDGEWAY, Robert Gordon, Quakertown, PA Pennsylvania 18951 (US); LEI, Xinjian, Vista, CA California 92081 (US); O'NEILL, Mark Leonard, Gilbert, AZ Arizona 85297 (US); JIANG, Xuezhong, Fogelsville, PA Pennsylvania 18051 (US)
(74) Representative: Beck Greener LLP

(56) References cited:
- EP-A1- 1 975 999
- US-A1- 2009 325 381
- US-A1- 2010 178 468
- US-A1- 2011 020 955
- US-A1- 2012 032 311
- YING-BING JIANG ET AL: "Nanometer-Thick Conformal Pore Sealing of Self-Assembled Mesoporous Silica by Plasma-Assisted Atomic Layer Deposition", JOURNAL OF THE AMERICAN CHEMICAL SOCIETY, vol. 128, no. 34, 1 August 2006 (2006-08-01), pages 11018-11019, XP055026774, ISSN: 0002-7863, DOI: 10.1021/ja061097d
- KIM CHANG YOUNG ET AL: "Method of sealing pores in porous low-kSiOC(-H) films fabricated using plasma-assisted atomic layer deposition", JOURNAL OF THE KOREAN PHYSICAL SOCIETY, KOREAN PHYSICAL SOCIETY, KR, vol. 62, no. 8, 8 May 2013 (2013-05-08), pages 1143-1149, XP035351826, ISSN: 0374-4884, DOI: 10.3938/JKPS.62.1143 [retrieved on 2013-05-08]

## Description

### BACKGROUND OF THE INVENTION

Described herein is a method and composition comprising same for sealing the pores of a porous low dielectric constant ("low k") layer by providing an additional thin dielectric film, referred to herein as a pore-sealing layer, on at least a surface of the porous, low k layer to prevent further loss of dielectric constant of the underlying layer.

One of the challenges facing integrated circuit (IC) manufacturers today is the integration of porous, low dielectric constant ("low k") materials with atomic layer deposition (ALD) or physical vapor deposition (PVD) metal films such as, but not limited to, copper, cobalt, or other metals or alloys thereof, at narrow device geometries. As the dielectric constants of the low k films or layers decrease below, for example, about 2.5, the percent porosity of these films is at about 30% or greater. As the porosity levels within these films increase, the pores begin to become more interconnected due to the shear number of pores in the film.

When these porous low k films are integrated, the films are typically first patterned using a photoresist and a reactive ion etching (RIE) plasma etch step using a fluorocarbon and oxygen with an optional hydrofluorocarbon. After the via and trenches are formed, the remaining photoresist is removed in a plasma ash step, which is generally either a hydrogen or oxygen plasma. Optionally, ammonia (NH₃) can be used in place of the hydrogen (H₂) or carbon dioxide (CO₂) can be used in place of oxygen (O₂). Typical porous low k films are comprised of porous organosilicate (OSG). During either the etch step, the ash step, or both, the porous OSG films are typically damaged in a manner in which the methyl groups bonded to Si in the film, or the Si-Me groups, near the surface are removed by reaction with neutral radicals that diffuse into the porous film. In certain instances, the Si-Me groups are converted to Si-OH groups which negatively impacts the hydrophobicity of the film. After the photoresist is removed, the barrier nitride on top of the metal film at the bottom of the via is typically removed in a "punch through" step to quickly remove the SiCN barrier nitride and expose the metal layer.

Typically, the next step is to deposit a barrier or a barrier layer to prevent metal diffusion in the feature. An example of a barrier layer is a tantalum nitride (TaN) layer with a metallic tantalum (Ta) layer deposited upon the TaN layer. Although both the TaN and Ta layers were traditionally deposited by physical vapor deposition (PVD) or sputtering, with shrinking feature sizes and the demand for thinner barriers, such as for copper, there has been a shift from PVD of TaN to atomic layer deposition (ALD) of TaN. The increased interconnectedness of the pores in the OSG films along with the plasma damage results in diffusion into the porous low k dielectric film of the metal precursors (such as, pentakis(dimethylamino)tantalum, Ta(NMe₂)₅) used to deposit ALD copper barriers (such as ALD Tantalum nitride), which adversely affects insulating properties of the film. In order to prevent the metal-containing precursor(s) from diffusing into the porous OSG during ALD, it is desirable to seal the surface of the porous OSG film before the ALD process. However, due to the narrowness of the trench and via features where the pores are exposed (e.g., trench width less than 20 nm), it is desirable that this pore sealing layer occupies as little space as possible. It would be also advantageous if the pore sealing occured inside the pores at or near the surface of the porous low k layer, such as the OSG layer, such that there is as little as possible pore sealing layer grown on top of the porous low k film, thus minimizing the loss of trench/via width.

U. S. Publ. No. 2013/0337583 describes a method, for repairing process related damage of a dielectric constant film, that includes (i) adsorbing a first gas containing silicon on the surface of the damaged dielectric film without depositing a film in the absence of reactive species; (ii) adsorbing a second gas containing silicon on the surface of the damaged dielectric film followed by applying a reactive species to the surface of the film to form a monolayer thereon, and (iii) repeating step (ii). The duration of the exposing the surface in step (i) is longer than the duration of exposing the surface to the second gas in step (ii).

U. S. Pat. No. 8,236,684 describes a method and apparatus for treating a porous dielectric layer which is capped by a dense dielectric layer. The dielectric layers are patterned and dense dielectric layer is deposited conformally over the substrate. The dense conformal dielectric layer seals the pores of the porous dielectric layer against contact from species that may infiltrate the pores.

U. S. Publ. No. 2014/0004717 describes a method for repairing and lowering the dielectric constant of a low-k dielectric layer by exposing the porous low-k dielectric layer to a vinyl silane containing compound and optionally exposing the porous low-k dielectric layer to an ultraviolet (U/V) cure process.

There are a number of challenges to overcome in developing a method to seal pores in the porous low k layer. First, because the metal (e.g., copper, cobalt, other metals, or alloys thereof) layer at the bottom of the via is exposed to the pore-sealing process, oxidizing environments should be avoided during the deposition of the pore sealing layer. Second, it is desirable to selectively deposit the pore sealing layer on/in the porous low k layer while not depositing a layer atop of the metal, which is a challenge with current processes. Lastly, since the pores of the low k material are to be sealed, the pore sealing material has to be selected so as to maintain the dielectric constant of the layer or, at the minimum, not significantly raise the dielectric constant such that the dielectric constant of the porous low k layer (having the pore sealing layer deposited thereupon or a sealed porous low k layer) remains 3.0 or less, or 2.9 or less, or 2.7 or less, or 2.5 or less, or 2.4 or less, or 2.3 or less, or 2.2 or less, or 2.1 or less. Accordingly, there remains a need for a process to seal pores in a via in a patterned, porous low k layer, such as without limitation a porous OSG layer, that addresses one or more of these challenges.

### SUMMARY OF THE INVENTION

The present invention satisfies one or more needs described above by providing a thin dielectric film, or a pore sealing layer, which seals the damaged pores of the underlying porous low k film and wherein the pore sealing layer provides one or more of the following: (a) prevents diffusion of the barrier metal into the porous low k film as measured by compositional analysis of the porous low k film; (b) minimizes the dielectric constant change of the underlying porous low k film, i.e. the difference between the dielectric constant for the porous low k film before the pore sealing layer is deposited thereupon and the dielectric constant after the pore sealing layer is deposited thereupon, for example so that the dielectric constant change is 0.5 or less, 0.4 or less, 0.3 or less, 0.2 or less, 0.1 or less; and (c) selectively deposits on the porous low k film relative to the metal (such as copper, cobalt, or other metal or alloys thereof) layer, for example so that the deposition rate of the pore sealing layer on the porous low k film is about 8 to about 10 times greater, or about 5 to about 8 times greater, or about 2 to about 5 times greater than the deposition rate of the pore sealing layer on the metal or copper layer.

In one aspect of the invention, there is provided a method for forming a pore sealing layer comprising the steps of:
a. providing a substrate having a porous low dielectric constant layer and a metal layer in a reactor, wherein the substrate has exposed SiOH groups contained within the porous low dielectric constrant layer that remain on the layer from one or more of the following manufacturing processes: etching, ash, planarization and/or combinations thereof;
b. contacting the substrate with at least one organosilicon compound selected from the group consisting of a compound having one of the following Formulae A through G:

| | | |
|---|---|---|
| (R⁴O)₃₋ₘSiR²R³ₘ | (R⁴O)₃₋ₙR²ₙSi-O-SiR²ₙ(OR³)₃₋ₙ | (R⁴COO)₃₋ₘSiR²R³ₘ |
| A | B | C |
| (R⁴COO)₃₋ₙR²ₙSi-O-SiR²ₙ(OOCR⁴)₃₋ₙ | 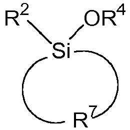 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |

wherein R² and R³ are each independently selected from the group consisting of a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; R⁵ is a linear or branched C₁₋₃ alkylene bridge; and R⁷ is selected from a C₂ to C₁₀ alkyl di-radical which forms a three-membered, four-membered, five-membered, or six-membered cyclic ring with the Si atom, and wherein m=0, 1, or 2 and n=0, 1 or 2, to provide an absorbed organosilicon compound on at least a portion of a surface of the porous low k dielectric layer;
c. purging the reactor with a purge gas;
d. introducing a plasma into the reactor to react with absorbed organosilicon compound, and
e. purging the reactor with a purge gas. wherein steps b through e are repeated until a desired thickness of a pore sealing film is formed on the surface and provides a sealed dielectric constant layer and wherein an oxidizing environment is avoided during the deposition of the pore sealing layer.

In certain embodiments, R² is selected from hydrogen, methyl, ethyl, propyl and vinyl. In certain embodiments, R³ is selected from methyl, ethyl, propyl and vinyl. In certain embodiments, R⁴ is selected from methyl, ethyl, propyl, butyl. In certain embodiments, R⁵ is a C₁ or C₂ alkylene bridge. In certain embodiments, R⁷ is a C₃ or C₄ alkyl di-radical which forms a four-membered orfive-membered cyclic ring with the Si atom. In certain embodiments, m=0 or 1. In certain embodiments, n=1 or 2. In certain embodiments, the porous low dielectric constant layer has a first dielectric constant and the sealed low dielectric constant layer has a second dielectric constant and the difference between the first dielectric constant and the second dielectric constant is 0.5 or less. In this or other embodiments, the substrate having the porous low dielectric constant layer may further comprise metal, wherein a first deposition rate of the pore sealing layer on the porous low dielectric constant layer is from 2 times greater to 10 times greater than a second deposition rate of the pore sealing layer on the metal.

### BRIEF DESCRIPTION OF THE DRAWINGS

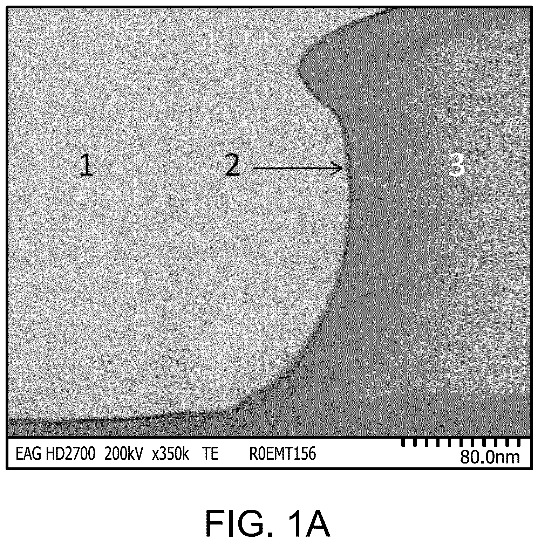

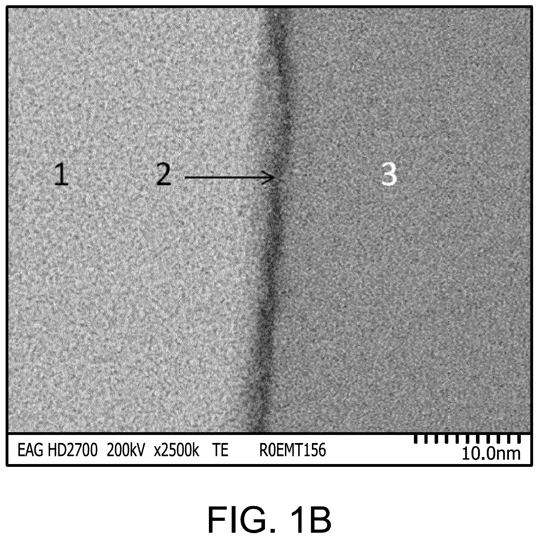

Figures 1(a) and (b) provide transmission electron microscopy (TEM) images of the sidewall of a patterned wafer comprising a porous low k dielectric film that was coated with a pore sealing layer in accordance with the method described in Example 1. Figures 1(a) and (b) show a clear interface between the Ta₂O₅ layer and porous low k dielectric layer which indicates a good pore-sealing effect of the pore sealing layer.

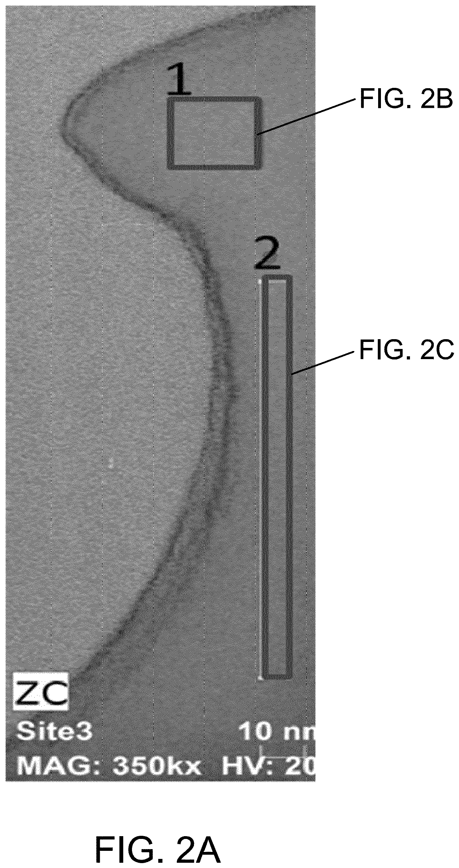

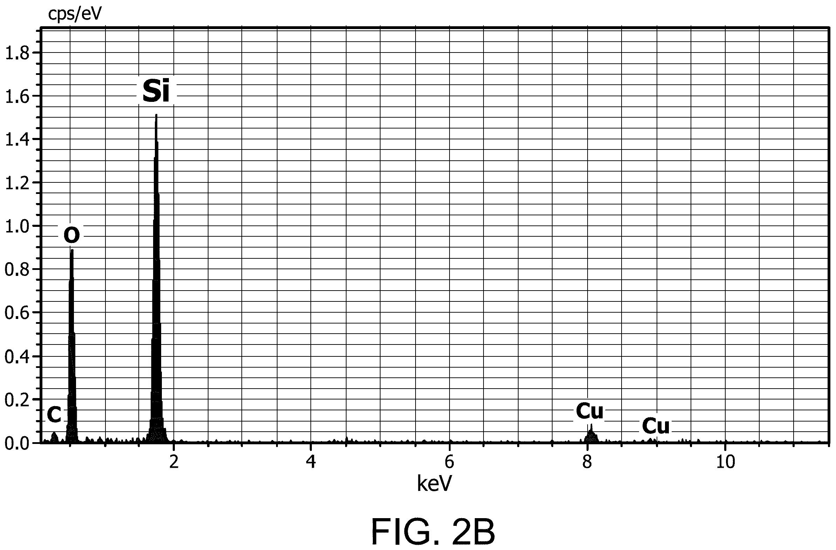

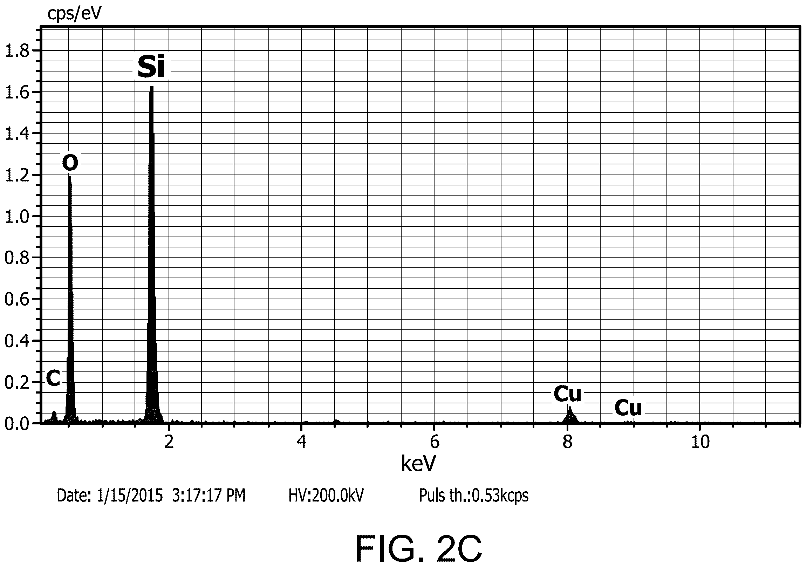

Figures 2(a), 2(b), and 2(c) provide a TEM image and energy dispersive X-ray spectroscopy (EDX) images obtained from the sidewall of a patterned wafer that was coated with a pore sealing layer deposited using the organosilicon compound trimethoxymethylsilane and a Ta₂O₅ layer deposited using pentakis(dimethylamino)tantalum, as described in Example 1. No Ta was detected in the porous low k dielectric layer.

### DETAILED DESRIPTION

Described herein is a composition and method using same wherein exposed SiOH groups, contained within a porous, low dielectric constant (low k) or organosilicate glass (OSG) film or layer, that remain on the film from one or more of the following manufacturing processes: etching, ash, planarization and/or combinations thereof, are used as an anchor for the plasma enhanced atomic layer deposition (ALD) of a pore sealing film or layer. Exemplary low k OSG films are deposited by a chemical vapor deposition (CVD) process using the silicon-containing precursor diethoxymethylsilane, such as the DEMS® precursor provided by Air Products and Chemicals, and a porogen precursor which is subsequently removed from the low k film using a thermal anneal, a ultraviolet cure (UV) step, or a combination thereof. The term "low dielectric constant film" or "low k film" means a low k film such as a porous OSG film that has a dielectric constant of 3.0 or less, or 2.7 or less, or 2.5 or less, or 2.3 or less. In certain embodiments, the porous low k film or layer comprises a cage and network structure consisting of at least one or more of the following bonds: Si-O, Si-CH₃, and Si-CHx bonds and further comprises pores or voids. In this or other embodiments, the low k films described herein further contain at least 15% or greater, at least 20% or greater, at least 25% or greater, or at least 30% or greater percent porosity as measured by ellipsometric porosimetry. The term "damaged porous low dielectric film" or "damaged low k film" means a low k film such as a porous OSG film that was subjected to one or more of the following manufacturing processes: etching, ash, planarization and/or combinations thereof.

In the method, a substrate having a damaged porous low k layer is placed into a reactor or deposition chamber. Then, at least a portion of the surface of a damaged porous low k dielectric layer, such as the horizontal surface of, for example, an etched via, is contacted with an organosilicon compound comprised of at least one compound selected from the group consisting of compounds of formulae A through G described herein to provide an absorbed organosilicon layer upon at a portion of the surface. Next, the low k porous layer is treated with at least one selected from ultraviolet (UV) light, a plasma comprising at least one plasma selected from plasma comprising at least one of nitrogen (N₂), argon (Ar), helium (He), hydrogen (H), ammonia (NH₃), and combination(s) thereof, or both. The contacting and treating process steps are repeated until a desired thickness of a pore sealing layer is formed on at least a portion of the surface the porous low k layer. As a result, the open pore(s) in the porous low k layer are sealed. Exemplary deposition methods for forming the pore sealing layer on at least a portion of the surface of the porous low k dielectric layer include, without limitation, plasma enhanced atomic layer deposition process (PEALD), plasma enhanced cyclic chemical vapor deposition (PECCVD), and a plasma enhanced ALD-like process

In one embodiment of the present invention, the surface of the low k layer is treated with an organosilicon compound having at least one alkoxy group having the formula A:

(R⁴O)₃₋ₘSiR²R³ₘ A

wherein R² and R³ are each independently selected from a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; and wherein m =0, 1, or 2. In certain preferred embodiments, R² may be selected from hydrogen, methyl, ethyl, propyl (such as for example isopropyl) and vinyl. In certain preferred embodiments, R³ may be selected from methyl, ethyl, and propyl (such as for example isopropyl) and vinyl. In certain preferred embodiments, R⁴ may be selected from methyl and ethyl. In certain preferred embodiments, m=0 or 1. Exemplary compounds having formula A include, but are not limited to, trimethoxymethylsilane, dimethoxydimethylsilane, triethoxymethylsilane, diethoxydimethylsilane, trimethoxysilane, dimethoxymethylsilane, di-isopropyldimethoxysilane, diethoxymethylsilane, dimethoxyvinylmethylsilane, dimethoxydivinylsilane, diethoxyvinylmethylsilane, and diethoxydivinylsilane. In embodiments wherein the damaged, porous low k film is contacted with the formula A organosilicon compound to form an absorbed organosilicon compound on at least a portion of the surface of the porous low k film, the substrate is preferably then treated with a plasma comprising at least one plasma selected from the group consisting of argon (Ar), helium (He), hydrogen (H), or combination(s) thereof, which plasma is introduced into the reactor to promote further reaction and form more Si-O-Si linkages. The process steps, of contacting at least a portion of the surface of the porous low k layer with the organosilicon compound and treating with plasma, are repeated until a desired thickness of the pore sealing layer is obtained. As a result, the open pore(s) in the underlying porous low k layer are sealed to provide a sealed porous low dielectric constant or porous low k layer.

The following scheme 1 provides an embodiment of the process described herein wherein at least a portion of the surface of a porous low k layer is contacted with an organosilicon compound having formula A wherein R² is a vinyl group to anchor the vinyl-containing silicon fragments on the surface via reaction of the organoamino groups of the organosilicon compound with Si-OH and provide absorbed organosilicon compound. The surface is then treated, with ultraviolet light, a plasma comprised of argon (Ar), helium (He), hydrogen (H), or combination(s), or both, to activate the reaction between the anchored vinyl-containing silicon fragments with Si-H and create at least one Si-CH₂CH₂-Si linkage with ultraviolet light (UV) and/or plasma. The process steps, of contacting the organosilicon compound with at least a portion of the surface of a porous low k layer and treating with UV, plasma, or both, are repeated until a desired thickness of the pore sealing layer is formed. As a result, the open pore in the low k layer is sealed to provide a sealed porous low dielectric constant or porous low k layer.

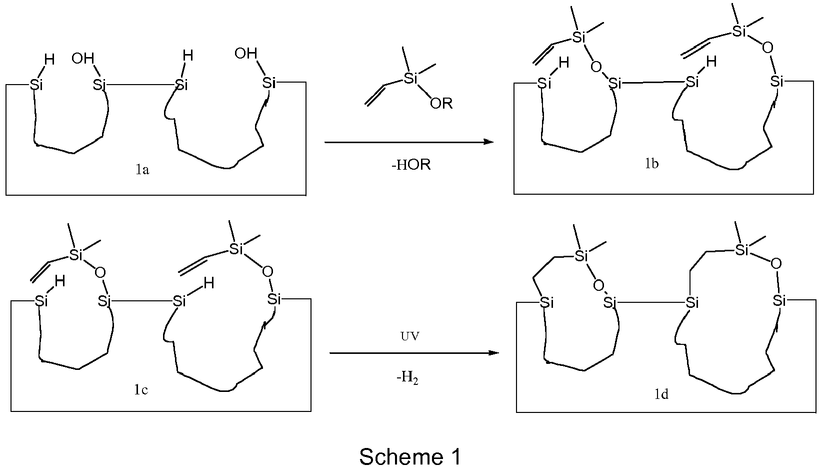

In another embodiment of the method described herein, the porous low k layer is contacted with an organosilicon compound having the following formula B which has at least one alkoxy group and a Si-O-Si linkage:

(R⁴O)₃₋ₙR²ₙSi-O-SiR²ₙ(OR⁴)₃₋ₙ B

wherein R² is selected from a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; and wherein n =0, 1, or 2; to provide an absorbed organosilicon compound on at least a portion of the surface. In certain preferred embodiments, R² may be methyl. In certain preferred embodiments, R⁴ may be methyl or ethyl. In certain preferred embodiments, n=1 or 2. Exemplary compounds having formula B include, but are not limited to, 1,1,3,3-tetramethoxy-1,3-dimethyldisiloxane, 1,1,3,3-tetraethoxy-1,3-dimethyldisiloxane,1,3-dimethoxy-1,1,3,3-tetramethyldisiloxane, and 1,3-diethoxy-1,1,3,3-tetramethyldisiloxane. The substrate is then treated with UV, a plasma comprising at least one plasma selected from the group consisting of argon (Ar), helium (He), hydrogen (H), or combination(s) thereof, or both, which is introduced into the reactor to promote further reaction and form more Si-O-Si linkages. The process steps of contacting the surface of a porous low k layer with the organosilicon compound and treatment with ultraviolet light (UV) and/or a plasma are repeated until a desired thickness of a pore sealing layer is obtained. As a result, the open pore(s) in the underlying porous low k layer are sealed to provide a sealed porous low dielectric constant or porous low k layer.

In another embodiment of the method described herein, the porous low k layer is contacted with an organosilicon compound having at least one carboxylic group as shown in the following formula C:

(R⁴COO)₃₋ₘSiR²R³ₘ C

wherein R² and R³ are each independently selected from a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; and wherein m = 0, 1, or 2. In certain preferred embodiments, R² may be methyl. In certain preferred embodiments, R³ may be methyl. In certain preferred embodiments, R⁴ may be methyl. In certain preferred embodiments, m=0 or 1. Exemplary compounds having formula C include, but are not limited to, dimethyldiacetoxysilane and methyltriacetoxysilane. The substrate is then treated with UV, a plasma comprising at least one plasma selected from the group consisting of argon (Ar), helium (He), hydrogen (H), or combination(s) thereof, or both, which is introduced into the reactor to promote further reaction and form more Si-O-Si linkages. The process steps of contacting the surface of a porous low k layer with the organosilicon compound and treatment with ultraviolet light (UV) and/or a plasma are repeated until a desired thickness of a pore sealing layer is obtained. As a result, the open pore(s) in the underlying porous low k layer are sealed.

In another embodiment of the method described herein, the porous low k layer is contacted with an organosilicon compound having at least one carboxylic group having a Si-O-Si linkage as shown in the following formula D:

(R⁴COO)₃₋ₙR²ₙSi-O-SiR²ₙ(OOCR⁴)₃₋ₙ D

wherein R² and R³ are selected from a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group; a C₃ to C₁₀ cyclic alkyl group, a C₃ to C₁₀ linear or branched alkenyl group, a C₃ to C₁₀ linear or branched alkynyl group, and a C₅-C₁₂ aryl group; and wherein n=0, 1 or 2. In certain preferred embodiments, R² may be methyl. In certain preferred embodiments, R⁴ may be methyl. In certain preferred embodiments, n=1 or 2. Exemplary compounds having formula D include, but are not limited to, 1,1,3,3-tetraacetoxy-1,3-dimethyldisiloxane and 1,3-tetraacetoxy-1,1,3,3-tetramethyldisiloxane. The substrate is then treated with UV, a plasma comprising at least one plasma selected from the group consisting of argon (Ar), helium (He), hydrogen (H), or combination(s) thereof, or both, which is introduced into the reactor to promote further reaction and form more Si-O-Si linkages. The process steps of contacting the surface of a porous low k layer with the organosilicon compound and treatment with ultraviolet light (UV) and/or a plasma are repeated until a desired thickness of a pore sealing layer is obtained. As a result, the open pore(s) in the underlying porous low k layer are sealed.

In another embodiment of the method described herein, the porous low k layer is contacted with an organosilicon compound having at least one alkoxy group as shown in the following formula E: 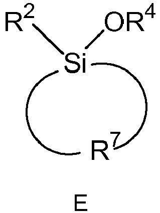 wherein R² is selected from a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; R⁷ is selected from a C₂ to C₁₀ alkyl di-radical which forms a three-membered, four-membered, five-membered, or six-membered cyclic ring with the Si atom. In certain preferred embodiments of formula E, R² is selected from a hydrogen, a methyl group, or a ethyl group. In certain preferred embodiments, R⁴ is selected from a methyl group, an ethyl group, a propyl group, and a butyl group. In certain preferred embodiments, R⁷ is a C₃ or C₄ alkyl di-radical which forms a four-membered or five-membered cyclic ring with the Si atom. Exemplary compounds having formula E include, but are not limited to, 1-methyl-1-methoxy-1-silacyclopentane, 1-methyl-1-ethoxy-1-silacyclopentane, 1-methyl-1-iso-propoxy-1-silacyclopentane, 1-methyl-1-n-propoxy-1-silacyclopentane, 1-methyl-1-n-butoxy-1-silacyclopentane, 1-methyl-1-sec-butoxy-1-silacyclopentane, 1-methyl-1-iso-butoxy-1-silacyclopentane, 1-methyl-1-tert-butoxy-1-silacyclopentane, 1-methoxy-1-silacyclopentane, 1-ethoxy-1-silacyclopentane, 1-methyl-1-methoxy-1-silacyclobutane, 1-methyl-1-ethoxy-1-silacyclobutane, 1-methoxy-1-silacyclobutane, and 1-ethoxy-1-silacyclobutane. The substrate is then treated with UV, a plasma comprising at least one plasma selected from the group consisting of argon (Ar), helium (He), hydrogen (H), or combination(s) thereof, or both, which is introduced into the reactor to promote further reaction and form more Si-O-Si linkages. The process steps of contacting the surface of a porous low k layer with the organosilicon compound and treatment with ultraviolet light (UV) and/or a plasma are repeated until a desired thickness of a pore sealing layer is obtained. As a result, the open pore(s) in the underlying porous low k layer are sealed.

In another embodiment of the method described herein, the porous low k layer is contacted with an organosilicon compound having at least one alkoxy group as shown in the following formula F:

(R⁴O)₃₋ₙR²ₙSi-R⁵-SiR²ₙ(OR⁴)₃₋ₙ F

wherein R² is independently selected from a hydrogen atom, a C₁ to C₁₀ linear alkyl group, C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C3to C₁₀ linear or branched alkynyl group, and a C₅-C₁₂ aryl group, R⁵ is a linear or branched C₁₋₃ alkylene bridge such as, but not limited to, a group containing 1, 2 or 3 carbon atoms, such as without limitation a methylene or an ethylene bridge and wherein n =0, 1 or 2. In certain preferred embodiments, R² is a methyl group. In certain preferred embodiments, R⁴ is a methyl group or an ethyl group. In certain preferred embodiments, R⁵ is a C₁ or C₂ alkylene bridge. In certain preferred embodiments, n=0 or 1. Exemplary compounds having formula F include, but are not limited to, 1,2-bis(dimethoxymethylsilyl)methane, 1,2-bis(diethoxymethylsilyl)methane, 1,2-bis(dimethoxymethylsilyl)ethane, 1,2-bis(trimethoxysilyl)ethane,and 1,2-bis(diethoxymethylsilyl)ethane. The substrate may then treated with UV, a plasma comprising at least one plasma selected from the group consisting of argon (Ar), helium (He), hydrogen (H), or combination(s) thereof, or both, which is introduced into the reactor to promote further reaction and form more Si-O-Si linkages. The process steps of contacting the surface of a porous low k layer with the organosilicon compound and treatment with ultraviolet light (UV) and/or a plasma may then be repeated until a desired thickness of a pore sealing layer is obtained. As a result, the open pore(s) in the underlying porous low k layer are sealed.

In another embodiment of the method described herein, the surface of a porous low k dielectric layer is contacted with an organosilicon compound having at least one organoamino anchoring group having the following formula G with a Si-O-Si linkage:

(R³R⁴N)₃₋ₙR²ₙSi-O-SiR²ₙ(NR³R⁴)₃₋ₙ G

wherein R² and R³ are each independently selected a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; and wherein n=0, 1 or 2. In certain preferred embodiments, R² may be methyl. In certain preferred embodiments, R³ may be selected from methyl, ethyl, and propyl. In certain preferred embodiments, R⁴ may be selected from methyl, ethyl, and propyl. In certain preferred embodiments, n=2. Exemplary compounds include having formula G include, but are not limited to, 1,3-dimethylamino-1,1,3,3-tetramethyldisiloxane, 1,3-diethylamino-1,1,3,3-tetramethyldisiloxane, and 1,3-di-sio-propylamino-1,1,3,3-tetramethyldisiloxane. The following Scheme 2 provides an embodiment of the method described herein wherein the damaged porous low k film is contacted with an organosilicon having Formula G and at least one anchoring group which reacts with the exposed Si-OH groups in the damaged porous low k dielectric film to allow the open pore to be sealed. 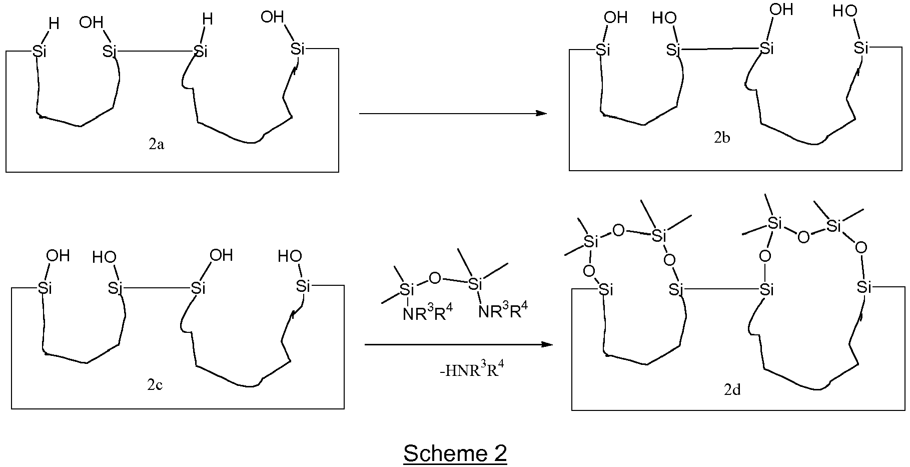 In this or other embodiments, the porous low k dielectric film is treated with UV, a plasma comprised of at least one plasma selected from argon (Ar), helium (He), hydrogen (H), or combination(s) thereof which is introduced into the reactor to promote further reaction to form more Si-O-Si linkages. The process steps, of contacting the surface of a low k layer with the organosilicon compound and treating with a plasma, are repeated until a desired thickness of pore sealing layer is formed. As a result, the open pore(s) in the underlying porous low k dielectric film are sealed.

In the formulae described herein and throughout the description, the term "alkyl" denotes a linear or branched functional group having from 1 to 10 or 3 to 10 carbon atoms, respectively. Exemplary linear alkyl groups include, but are not limited to, methyl (Me), ethyl (Et), propyl (n-Pr), butyl (n-Bu), pentyl, and hexyl. Exemplary branched alkyl groups include, but are not limited to, iso-propyl (iso-Pr or ⁱPr), isobutyl (ⁱBu), sec-butyl (^{s}Bu), tert-butyl ('Bu), iso-pentyl, tert-pentyl (amyl), iso-hexyl, and neo-hexyl. In certain embodiments, the alkyl group may be substituted with one or more functional groups such as, but not limited to, an alkoxy group, a dialkylamino group or combinations thereof, attached thereto. In other embodiments, the alkyl group does not have one or more functional groups or hetero atoms attached thereto.

In the formulae described herein and throughout the description, the term "cyclic alkyl" denotes a cyclic functional group having from 3 to 10 or from 4 to 10 carbon atoms or from 5 to 10 carbon atoms. Exemplary cyclic alkyl groups include, but are not limited to, cyclobutyl, cyclopentyl, cyclohexyl, and cyclooctyl groups.

In the formulae described herein and throughout the description, the term "aryl" (which term is used herein to also encompass aralkyl groups) denotes an aromatic cyclic functional group having from 5 to 12 carbon atoms or from 6 to 10 carbon atoms. Exemplary aryl groups include, but are not limited to, phenyl, benzyl, chlorobenzyl, tolyl, and o-xylyl.

In the formulae described herein and throughout the description, the term "alkenyl group" denotes a group which has one or more carbon-carbon double bonds and has from 2 to 10 or from 3 to 6 or from 3 to 4 carbon atoms.

In the formulae described herein and throughout the description, the term "alkynyl group" denotes a group which has one or more carbon-carbon triple bonds and has from 2 to 10 or from 3 to 6 or from 3 to 4 carbon atoms.

In the formulae described herein and throughout the description, the term "alkoxy group" denotes a group derived from alcohol via removal of a proton. Exemplary alkoxy group include, but are not limited, methoxy, ethoxy, iso-propoxy, n-propoxy, tert-butoxy, sec-butoxy, iso-butoxy.

In the formulae described herein and throughout the description, the term "carboxylic group" denotes a group derived from carboxylic acid via removal of a proton. Exemplary carboxylic group include, but are not limited, acetoxy (MeCOO).

In the formulae described herein and throughout the description, the term "alkylene bridge" denotes a di-radical derived from an alkyl having 1 to 10 carbon atoms, preferably 1 to 4 carbon atoms. Exemplary alkylene bridges include, but are not limited to, -CH₂- (methylene), -CH₂CH₂- (ethylene), -CH(Me)CH₂- (iso-propylene), -CH₂CH₂CH₂-(propylene).

In the formulae described herein and throughout the description, the term "cyclic alkyl" denotes a cyclic functional group having from 3 to 10 or from 4 to 10 carbon atoms or from 5 to 10 carbon atoms. Exemplary cyclic alkyl groups include, but are not limited to, cyclobutyl, cyclopentyl, cyclohexyl, and cyclooctyl groups. In the formulas above and through the description, the term "unsaturated" as used herein means that the functional group, substituent, ring or bridge has one or more carbon double or triple bonds. An example of an unsaturated ring can be, without limitation, an aromatic ring such as a phenyl ring. The term "saturated" means that the functional group, substituent, ring or bridge does not have one or more double or triple bonds.

In certain embodiments, one or more of the alkyl group, alkenyl group, alkynyl group, cyclic group and/or aryl group may be substituted or have one or more atoms or group of atoms such as functional groups substituted in place of, for example, a hydrogen atom. Exemplary substituents include, but are not limited to, oxygen, sulfur, halogen atoms (e.g., F, Cl, I, or Br), nitrogen, and phosphorous. Further exemplary substituents include where the alkyl group may have one or more functional groups such as, but not limited to, an alkoxy group, a dialkylamino group or combinations thereof, attached thereto. In other embodiments, one or more of the alkyl group, alkenyl group, alkynyl group, cyclic group and/or aryl group in the formulae described herein does not have one or more functional groups attached thereto.

In the method described above, while not being bound by theory, it is believed that the pore sealing layer selectively deposits on at least a portion of the porous low k dielectric layer vs. metal such as copper, cobalt or alloys thereof, because the molecule is anchored to the film surface due to the reaction with -OH, which does not exist on the surface of metal in the reductive atmosphere. Thus, no deposition can occur on the surface of metal, resulting in good selectivity with respect to the porous low k dielectric layer. For selectivity of deposition of the pore sealing layer onto the porous low k film compared to the metal such as copper, it is preferred the deposition rate of the pore sealing film on the porous low k film relative to metal ranges from one or more of the following end points: about 2 times greater, about 3 times greater, about 4 times greater, about 5 times greater, about 6 times greater, about 7 times greater, about 8 times greater, about 9 times greater, and about 10 times greater. Exemplary ranges include, but are not limited to the following: about 8 to about 10 times greater, or about 5 to about 8 times greater, or about 2 to about 5 times greater. In this or other embodiments, the substrate having the porous low dielectric constant layer may further comprise metal, and a first deposition rate of the pore sealing layer on the porous low dielectric constant layer may be from 2 times greater to 10 times greater than a second deposition rate of the pore sealing layer on the metal portion of the substrate.

It is expected that the open pores will be sealed after about 10 to 30 cycles of method described herein. It will be appreciated that the resultant pore sealing layer that is deposited onto the low k dielectric film is relatively thin, or has a thickness of about 5 nanometers (nm) or less, 4 nm or less, 3nm or less, 2nm or less, or 1nm or less, or 0.5 nm or less.

A minimum dielectric constant shift may be necessary for the pore sealing layer to minimize the impact on the electrical performance of the device based on the underlying porous low k dielectric layer. The change for dielectric constant k (i.e. the difference between the dielectric constant for the porous low k film before and after pore sealing layer is applied, or the difference in dielectric constant before and after the porous low dielectric constant film is sealed) is 0.5 or less, 0.4 or less, 0.3 or less, 0.2 or less, 0.1 or less. In certain embodiments, the porous low dielectric constant layer has a first dielectric constant and the sealed low dielectric constant layer has a second dielectric constant and the difference between the first dielectric constant and the second dielectric constant is 0.5 or less, 0.4 or less, 0.3 or less, 0.2 or less, 0.1 or less, or 0.05 or less.

The ALD-like process is defined herein as a cyclic CVD process that provides a high conformal pore sealing layer on at least a portion of the porous low k dielectric film. The pore sealing layer can be comprised of silicon-containing film such as amorphous silicon, silicon oxide, carbon doped silicon oxide, silicon carbonitride, silicon nitride. In certain embodiments, the pore sealing layer has a percentage of non-uniformity of 5% or less, a deposition rate of 1 Å or greater per cycle, or both.

The deposition methods described herein may involve one or more purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon (Ne), hydrogen (H₂), and mixtures thereof. In certain embodiments, a purge gas such as Ar is supplied into the reactor at a flow rate ranging from about 10 to about 2000 sccm for about 0.1 to 1000 seconds, thereby purging the unreacted material and any byproduct that may remain in the reactor.

Energy is applied to the at least one of the organosilicon compound to induce reaction and to form the pore sealing film or coating on the substrate. Such energy can be provided by, but not limited to, thermal, plasma, pulsed plasma, helicon plasma, high density plasma, inductively coupled plasma, X-ray, e-beam, photon, remote plasma methods, and combinations thereof. In certain embodiments, a secondary RF source can be used to modify the plasma characteristics at the substrate surface. In embodiments wherein the deposition involves plasma, the plasma-generated process may comprise a direct plasma-generated process in which plasma is directly generated in the reactor, or alternatively a remote plasma-generated process in which plasma is generated outside of the reactor and supplied into the reactor.

The organosilicon compounds precursors and/or other silicon-containing precursors may be delivered to the reactor in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate.

In certain embodiments, the method described herein is conducted using a cyclic process on a PECVD/PEALD platform. The silicon wafer susceptor is maintained in at one or more temperatures ranging from about 100 to about 400°C, or about 200 to about 300°C. The liquid organosilicon compound is delivered into the reactor under vacuum at a rate of 50-5000 mg/min (preferably 200-300 mg/min) with the chamber throttle valve closed. After the liquid flow of compound is turned off, the wafer is allowed to contact the compound or "soak" in the reactor with the precursor vapor at pressures of 1∼8 Torr (0.1∼1.0 kPa), preferably 2-4 Torr (0.3∼0.5 kPa). The throttle valve is subsequently opened with inert gas purging for a time ranging from about 10 to about 300 seconds or from about 30 to about 50 seconds. Then, the wafer is treated with UV, a plasma comprising a reactant gas such as N₂, He, Ar, H₂, a plasma comprising an inert gas (He, Ar) in the reactor to activate and react the adsorbed organosilicon precursor while preparing the surface of the growing film for reaction with the next pulse or contact with the organosilicon compound. The power of the plasma in the treatment step ranges from 50 to 3000 W, preferably 200∼300 W with plasma exposure times of 10-60 seconds (sec.), preferably 15 sec. This sequence of events completes one process cycle, which is repeated 10-30 times to provide the pore sealing layer.

In one embodiment, there is provided a method of forming a pore sealing layer via plasma enhanced atomic layer deposition process (PEALD), plasma enhanced cyclic chemical vapor deposition (PECCVD) or plasma enhanced ALD-like process. In this embodiment, the method comprises the steps of:
a. providing a substrate having a porous low dielectric constant layer in a reactor;
b. contacting the substrate with at least one organosilicon compound selected from the group consisting of a compound having one of the following Formulae A through G:

| | | |
|---|---|---|
| (R⁴O)₃₋ₘSiR²R³ₘ | (R⁴O)₃₋ₙR²ₙSi-O-SiR²ₙ(OR³)₃₋ₙ | (R⁴COO)₃₋ₘSiR²R³ₘ |
| A | B | C |
| (R⁴COO)₃₋ₙR²ₙSi-O-SiR²ₙ(OOCR⁴)₃₋ₙ | 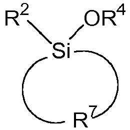 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |

wherein R² and R³ are each independently selected from the group consisting of a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; R⁵ is a linear or branched C₁₋₃ alkylene bridge; and R⁷ is selected from a C₂ to C₁₀ alkyl di-radical which forms a three-membered, four-membered, five-membered, or six-membered cyclic ring with the Si atom, and wherein m=0, 1, or 2 and n=0, 1 or 2, to provide an absorbed organosilicon compound on at least a portion of a surface of the porous low dielectric constant layer;
c. purging the reactor with a purge gas;
d. introducing a plasma into the reactor to react with absorbed organosilicon compound, and
e. purging the reactor with a purge gas; wherein steps b through e are repeated until a desired thickness of a pore sealing film is formed on the surface.

In yet another aspect, there is provided a method of forming a pore sealing layer via plasma enhanced atomic layer deposition process (PEALD), plasma enhanced cyclic chemical vapor deposition (PECCVD) or plasma enhanced ALD-like process, the method comprising the steps of:
a. providing a substrate having a porous low dielectric constant layer in a reactor;
b. contacting the substrate with at least one organosilicon compound selected from the group consisting of a compound having one of the following Formulae A through G:

| | | |
|---|---|---|
| (R⁴O)₃₋ₘSiR²R³ₘ | (R⁴O)₃₋ₙR²ₙSi-O-SiR²ₙ(OR³)₃₋ₙ | (R⁴COO)₃₋ₘSiR²R³ₘ |
| A | B | C |
| (R⁴COO)₃₋ₙR²ₙSi-O-SiR²ₙ(OOCR⁴)₃₋ₙ | 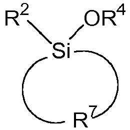 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |

wherein R² and R³ are each independently selected from the group consisting of a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; R⁵ is a linear or branched C₁₋₃ alkylene bridge; and R⁷ is selected from a C₂ to C₁₀ alkyl di-radical which forms a three-membered, four-membered, five-membered, or six-membered cyclic ring with the Si atom, and wherein m=0, 1, or 2 and n=0, 1 or 2, to provide an absorbed organosilicon compound on at least a portion of a surface of the porous low dielectric constant layer;
c. purging the reactor with a purge gas;
d. introducing a plasma into the reactor to react with absorbed organosilicon compound, and
e. purging the reactor with a purge gas;
f. introducing into the reactor at least one organosilicon compound having Formula A through G wherein the at least one organosilicon compound which differs from the at least one organosilicon in method step b;
g. purging the reactor with a purge gas;
h. introducing a plasma into the reactor to react with absorbed organosilicon compound;
i. purging the reactor with a purge gas, wherein steps b through i are repeated until a desired thickness of the film is obtained. In some embodiment, step b to e are repeated for some cycles before steps f to i are repeated for a certain number of cycles. In one particular embodiment, an organosilicon compound having an Si-H bond such as diethoxymethylsilane is used in step b to allow the reduction of copper oxide into copper metal, thus facilitating the selective deposition of the pore sealing layer on the surface of porous low k dielectric layer.

### EXAMPLES

### General Pore Sealing Layer Deposition Experiment and Results

A variety of experiments for depositing different types of pore sealing layers, under different deposition conditions, were conducted on 200 millimeter (mm) wafers carrying a layer of a porous diethoxymethylsilane film having a dielectric constant of 2.2. The layer of a porous diethoxymethylsilane film was deposited from the structure-former diethoxymethylsilane (DEMS) precursor and porogen precursor cyclooctane, and was ultraviolet (UV) cured, as described in US Publ. No.: 2007/0299239.

All the methods for depositing the pore sealing layer were performed on an Applied Materials Precision 5000 system in a 200 mm DXZ chamber fitted with an Astron EX remote plasma generator, using either a silane or a TEOS process kit. The plasma enhanced chemical vapor deposition (PECVD) chamber was equipped with direct liquid injection (DLI) delivery capability. Precursors were liquids at the delivery temperatures and were dependent on the precursor's boiling point. The low-k wafers were damaged to provide a "damaged porous low k dielectric film" with a short NH₃ plasma which removed a portion of the Si-Me groups from the surface of the pores down to a depth of 50 nm to mimic the integration damage caused by etch and ash. The wafers having the damaged porous low k dielectric film were sealed with a pore sealing layer that was deposited using a plasma-enhanced atomic layer deposition (PEALD) process on the PECVD tool.

Thickness and refractive index (RI) at 632 nm were measured by a reflectometer (SCI-2000) and an ellipsometer (J. A. Woollam M2000UI). One test to determine if the pore sealing layer was successful was the ellipsometric porosimetry (EP) test. The EP test monitors the wafer color change and ellipsometric spectra shift, which is caused by the toluene vapor diffusing into the unsealed pores. The thickness of the pore sealing layer was analyzed by X-ray reflectivity (XRR), X-ray Photoelectron Spectroscopy (XPS) profiling, and transmission electron microscopy (TEM). A layer of tantalum nitride (TaN) or tantalum oxide (Ta₂O₅) was deposited on the wafer, using ALD and the precursor pentakis(dimethylamino)tantalum and NH₃ or H₂O, respectively. The thickness of TaN or Ta₂O₅ was measured by X-ray fluorescence (XRF). The copper selectivity was performed by repeating the deposition of the pore sealing layer on bare copper (Cu) wafers and measuring the thickness of the pore sealing layer using energy-dispersive X-ray spectroscopy (EDX) and XPS and then comparing the respective thicknesses (e.g., the thickness of the deposited pore sealing layer on the damaged porous low k dielectric film vs. thickness of the deposited pore sealing layer on the bare Cu wafer).

In these experiments, different organosilicon precursors for forming the pore sealing layer were tested under the following conditions. PDEMS films having an initial dielectric constant of 2.2 were damaged at 300°C with 300 W NH₃ plasma for 15 seconds to provide a damaged porous low k film to be used in the following examples. Organosilicon precursor compounds were introduced into the reactor at a flow rate of 300 milligrams per minute (mg/min) for 1 minute (min) with the throttle valve closed at one or more temperatures ranging from about 200 to about 300°C. The wafers were contacted or soaked in the precursor vapor for 2 min and then the chamber was purged with helium for 2 min. Next, the sample was exposed to a 15 second (sec) Helium (He) plasma at a power setting of 200 Watts (W). These process steps (e.g., expose to precursor, purge, and then expose to plasma) were then repeated for approximately 10 to approximately 30 cycles.

### Example 1: Formation of a Pore Sealing Layer Using Organosilicon Compound Trimethoxymethylsilane having Formula A

In the present example, the dielectric constant of the pore sealing layer was kept relatively low by using non-nitrogen containing precursors or gases in the process. The use of oxygen or other oxidants was excluded to prevent the oxidization of copper surfaces. The damaged porous low k film was contacted with the organosilicon compound trimethoxymethylsilane (C₄H₁₂O₃Si) and treated with a helium plasma. In each cycle, a 200 Watt He plasma was used for 15 seconds after the organosilicon precursor compound was introduced into the reactor, allowed to soak onto the surface of the damaged porous low k dielectric film, and then purged. The process was repeated approximately 10 to 30 times to provide the pore sealing layer. The pore sealing layer was deemed effective because no toluene diffused into the damaged porous low k film as evidenced by no color change observed or ellipsometric spectrum shift by the toluene vapor diffusion after 30 cycles of treatment. Next, a Ta₂O₅ layer was deposited onto the wafer, having the pore sealing layer deposited thereupon, with 10 cycles of treatment. After the Ta-containing layer was deposited, there was no indication of Ta diffusion into the pores as tested by X-ray fluorescence (XRF). Therefore, the damaged pores are sealed by forming a pore sealing layer after 10 cycles of contacting with trimethoxymethylsilane and treating with He plasma.

To verify the deposition rate of the pore-sealing layer, the pore-sealing process was conducted for 60 cycles. The film thickness of the pore sealing layer was -5.8 nanometers (nm), which indicated that the deposition rate was less than 1 A per cycle. The dielectric constant of the pore sealing layer was about 3.2 to about 3.4, which will not significantly increase k after the pore sealing is complete.

A separate deposition of the pore sealing layer using trimethoxymethylsilane was conducted on a Cu substrate as described above. These depositions showed some selectivity on Cu: with 10 cycles treatment on the bare Cu, a less than 3 angstrom thick SiO₂ of pore sealing layer was detected by XPS profiling. Therefore, a 3:1 selectivity on Cu was demonstrated when compared to the pore sealing layer deposited upon the damaged, porous low k dielectric film.

Ten cycles of the deposition of the pore sealing layer (e.g., expose to precursor, purge, and then expose to plasma) were also conducted on patterned OSG low-k films followed by ALD Ta₂O₅ deposition. Figures 1a and 1b provide TEM images that show the sidewall of the substrate wherein 1 is a carbon layer, 2 is the Ta₂O₅ layer, and 3 is the porous low k dielectric layer. The pore sealing layer between items 2 and 3 is too thin to be shown on the TEM image. Figures 1a and 1b showed good pore-sealing effect without Ta diffusion into the underling low k dielectric film. A clear interface was shown between the Ta₂O₅ layer and the low-k dielectric layer, as shown in Figure 1 (a) and (b). Figures 2b and 2c provide the EDX obtained from various areas on the sidewall shown in Figure 2a, which confirms that there is no detectable Ta in the porous low k dielectric layer 3.

### Example 2: Pore Sealing with Di-isopropyldimethoxysilane (Formula A)

A pore sealing layer was deposited using the organosilicon compound di-isopropyldimethoxysilane (C₈H₂₀OSi) as described above and was found to be suitable for sealing the pores without dramatically raising the dielectric constant compared to undamaged low k films. With up to 30 cycles treatment, the dielectric constant of the low k film only increased from a starting value of 2.2 to a post treatment value of 2.29 (or a change of +0.09). This organosilicon compound was also found to provide relatively good selectivity on a Cu substrate: with 20 cycles treatment, the thickness of pore sealing layer on low k film is about 20 angstroms, whereas the thickness of pore sealing layer on the Cu surface is less than 3.4 A, which showed approximately 6:1 selectivity.

### Example 3: Pore Sealing with Dimethyldiacetoxysilane (Formula C)

A pore sealing layer was deposited using dimethyldiacetoxysilane (C₆H₁₂O₄Si) as described above. The damaged porous low k film was completely sealed with 10 cycles of contacting with the organosilicon compound and then He plasma treatment The film deposition rate was -1.2 A/cycle, which indicates that the pores can be sealed with a pore sealing layer having a thickness of about 1.2 nanometers (nm). Meanwhile, the dielectric constant of the capping layer is less than 4, which is also has potential to reduce the k shift. Ta₂O₅ deposition and XRF analysis indicated that the pores were sealed with no Ta diffusion into the pores.

### Example 4: Pore Sealing with 1-methyl-1-ethoxy-1-silacyclopentane (Formula E)

The organosilicon precursor 1-methyl-1-ethoxy-1-silacyclopentane having formula C₇H₁₆OSi was tested as described above. The NH₃ damaged film was completely sealed with 10 cycles He or Ar plasma treatment. Ta₂O₅ deposition and XRF analysis indicate that the pores were sealed with no Ta diffusion into the pores. The dynamic SIMS data also showed a dramatic Ta concentration drop at the interface, indicating good pore-sealing effect by 10 cycles of the method described herein.

### Example 5: Pore Sealing with 1,2-Bis(trimethoxysilyl)ethane (Formula F)

Damaged, porous low k dielectric films as described above were contacted with the organosilicon compound 1,2-Bis(trimethoxysilyl)ethane [(CH₃O)₃Si-(CH₂)₂-Si(OCH₃)₃] having formula C₈H₂₂O₆Si₂ and were tested using the EP test as described above, and passed the EP test with no toluene diffusion. No color change was observed; no ellipsometer shift occurred. XRF analysis also indicated that there was no Ta diffusion into the pores after 10 cycles treatment by 1,2-Bis(trimethoxysilyl)ethane.

## Claims

1. A method for forming a pore sealing layer, the method comprising the steps of:
a. providing a substrate having a porous low dielectric constant layer (3) and a metal layer in a reactor, wherein the substrate has exposed SiOH groups contained within the porous low dielectric constant layer (3) that remain on the layer from one or more of the following manufacturing processes: etching, ash, planarization and/or combinations thereof;
b. contacting the substrate with at least one organosilicon compound selected from the group consisting of a compound having one of the following Formulae A through G:
| | | |
|---|---|---|
| (R⁴O)₃₋ₘSiR²R³ₘ | (R⁴O)₃₋ₙR²ₙSi-O-SiR²ₙ(OR³)₃₋ₙ | (R⁴COO)₃₋ₘSiR²R³ₘ |
| A | B | C |
| (R⁴COO)₃₋ₙR²ₙSi-O-SiR²ₙ(OOCR⁴)₃₋ₙ | 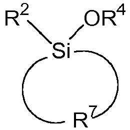 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |
wherein R² and R³ are each independently selected from the group consisting of a hydrogen atom, a C₁ to C₁₀ linear alkyl group, a C₃ to C₁₀ branched alkyl group, a C₃ to C₁₀ cyclic alkyl group, a C₅ to C₁₂ aryl group, a C₂ to C₁₀ linear or branched alkenyl group, and a C₂ to C₁₀ linear or branched alkynyl group; R⁴ is selected from a C₁ to C₁₀ linear alkyl group, a C₃ to C₁₀ branched alkyl group, a C₃ to C₁₀ cyclic alkyl group, a C₃ to C₁₀ linear or branched alkenyl group, a C₃ to C₁₀ linear or branched alkynyl group, and a C₅-C₁₂ aryl group; R⁵ is a linear or branched C₁₋₃ alkylene bridge; and R⁷ is selected from a C₂ to C₁₀ alkyl di-radical which forms a three-membered, four-membered, five-membered, or six-membered cyclic ring with the Si atom, and wherein m=0, 1, or 2 and n=0, 1 or 2, to provide an absorbed organosilicon compound on at least a portion of a surface of the porous low dielectric constant layer (3);
c. purging the reactor with a purge gas;
d. introducing a plasma into the reactor to react with absorbed organosilicon compound, and
e. purging the reactor with a purge gas;
wherein steps b through e are repeated until a desired thickness of the pore sealing layer is formed on the surface and provides a sealed dielectric constant layer and
wherein an oxidizing environment is avoided during the deposition of the pore sealing layer.

2. The method of claim 1, wherein R² is selected from hydrogen, methyl, ethyl, propyl and vinyl; R³ is, where present, selected from methyl, ethyl, propyl and vinyl; R⁴ is selected from methyl, ethyl, propyl, butyl; R⁵ is, where present, a C₁ or C₂ alkylene bridge; and R⁷ is, where present, a C₃ or C₄ alkyl di-radical which forms a four-membered or five-membered cyclic ring with the Si atom.

3. The method of claims 1 or 2, wherein m=0 or 1 and n=1 or 2.

4. The method of any one of claims 1 to 3 wherein the at least one organosilicon compound comprises the compound having Formula A and is selected from the group consisting of trimethoxymethylsilane, dimethoxydimethylsilane, triethoxymethylsilane, diethoxydimethylsilane, trimethoxysilane, dimethoxymethylsilane, diethoxymethylsilane, dimethoxyvinylmethylsilane, dimethoxydivinylsilane, diethoxyvinylmethylsilane, diethoxydivinylsilane, and diisopropyldimethoxysilane.

5. The method of any one of claims 1 to 3 wherein the at least one organosilicon compound comprises the compound having Formula B and is selected from the group consisting of 1,1,3,3-tetramethoxy-1,3-dimethyldisiloxane, 1,1,3,3-tetraethoxy-1,3-dimethyldisiloxane,1,3-dimethoxy-1,1,3,3-tetramethyldisiloxane, and 1,3-diethoxy-1,1,3, 3-tetramethyldisiloxane.

6. The method of any one of claims 1 to 3 wherein the at least one organosilicon compound comprises the compound having Formula C and is selected from the group consisting of dimethyldiacetoxysilane and methyltriacetoxysilane.

7. The method of any one of claims 1 to 3 wherein the at least one organosilicon compound comprises the compound having Formula D and is selected from the group consisting of 1,1,3,3-tetraacetoxy-1,3-dimethyldisiloxane and 1,3-tetraacetoxy-1,1,3,3-tetramethyldisiloxane.

8. The method of any one of claims 1 to 3 wherein the at least one organosilicon compound comprises the compound having Formula E and is selected from the group consisting of 1-methyl-1-methoxy-1-silacyclopentane, 1-methyl-1-ethoxy-1-silacyclopentane, 1-methyl-1-iso-propoxy-1-silacyclopentane, 1-methyl-1-n-propoxy-1-silacyclopentane, 1-methyl-1-n-butoxy-1-silacyclopentane, 1-methyl-1-sec-butoxy-1-silacyclopentane, 1-methyl-1-iso-butoxy-1-silacyclopentane, 1-methyl-1-tert-butoxy-1-silacyclopentane, 1-methoxy-1-silacyclopentane, 1-ethoxy-1-silacyclopentane, 1-methyl-1-methoxy-1-silacyclobutane, 1-methyl-1-ethoxy-1-silacyclobutane, 1-methoxy-1-silacyclobutane, and 1-ethoxy-1-silacyclobutane.

9. The method of any one of claims 1 to 3 wherein the at least one organosilicon compound comprises the compound having Formula F and is selected from the group consisting of 1,2-bis(dimethoymethylsilyl)methane, 1,2-bis(diethoymethylsilyl)methane, 1,2-bis(dimethoymethylsilyl)ethane, 1,2-bis(diethoymethylsilyl)ethane, and 1,2-Bis(trimethoxysilyl)ethane.

10. The method of any preceding claim wherein the thickness of the pore sealing layer is 5 nanometers or less, 3 nanometers or less, or 1 nanometer or less.

11. The method of any preceding claim wherein the porous low dielectric constant layer (3) has a first dielectric constant and the sealed low dielectric constant layer has a second dielectric constant and a difference between the first dielectric constant and the second dielectric constant is 0.5 or less, 0.4 or less, or 0.2 or less.

12. The method of any preceding claim wherein a first deposition rate of the pore sealing layer on the porous low dielectric constant layer (3) is from 2 times greater to 10 times greater than a second deposition rate of the pore sealing layer on the metal.

13. The method of any preceding claim, wherein the method is a method of forming a pore sealing layer via plasma enhanced atomic layer deposition process (PEALD), plasma enhanced cyclic chemical vapor deposition (PECCVD) or plasma enhanced ALD-like process, and the method further comprises the steps of:
f. introducing into the reactor at least one organosilicon compound having Formulae A through G wherein the at least one organosilicon compound which differs from the at least one organosilicon in method step b;
g. purging the reactor with a purge gas;
h. introducing a plasma into the reactor to react with absorbed organosilicon compound; and
i. purging the reactor with a purge gas;
wherein steps b through i are repeated until a desired thickness of the film is obtained.

14. The method of Claim 13, wherein steps b to e are repeated for a certain number of cycles and then steps f to i are repeated for a certain number of cycles.

## Patentansprüche

1. Verfahren zum Bilden einer Porenversiegelungsschicht, wobei das Verfahren die Schritte umfasst:
a. Bereitstellen eines Substrats, das eine poröse Schicht mit niedriger Dielektrizitätskonstante (3) und eine Metallschicht in einem Reaktor aufweist, wobei das Substrat exponierte SiOH-Gruppen aufweist, die in der porösen Schicht mit niedriger Dielektrizitätskonstante (3) enthalten sind, die bei einem oder mehreren der folgenden Herstellungsverfahren auf der Schicht verbleiben: Ätzen, Veraschen, Planarisierung und/oder Kombinationen davon;
b. Kontaktieren des Substrats mit mindestens einer Organosiliziumverbindung, die aus der Gruppe bestehend aus einer Verbindung mit einer der folgenden Formeln A bis G ausgewählt ist:
| | | |
|---|---|---|
| (R⁴O)₃₋ₘSiR²R³m | (R⁴O)₃₋ₙR²ₘSi-O-SiR²ₙ(OR³)₃₋ₙ | (R⁴COO)₃₋ₘSiR²R³ₘ |
| A | B | C |
| (R⁴COO)₃₋ₙR²ₙSi-O-SiR²ₙ(OOCR⁴)₃₋ₙ | 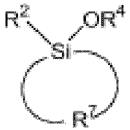 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |
wobei R² und R³ jeweils unabhängig aus der Gruppe bestehend aus einem Wasserstoffatom, einer linearen C₁- bis C₁₀-Alkylgruppe, einer verzweigten C₃- bis C₁₀-Alkylgruppe, einer zyklischen C₃-bis C₁₀-Alkylgruppe, einer C₅- bis C₁₂-Arylgruppe, einer linearen oder verzweigten C₂- bis C₁₀-Alkenylgruppe und einer linearen oder verzweigten C₂- bis C₁₀-Alkynylgruppe ausgewählt ist; R⁴ aus einer linearen C₁-bis C₁₀-Alkylgruppe, einer verzweigten C₃- bis C₁₀-Alkylgruppe, einer zyklischen C₃- bis C₁₀-Alkylgruppe, einer linearen oder verzweigten C₃- bis C₁₀-Alkenylgruppe, einer linearen oder verzweigten C₃- bis C₁₀-Alkynylgruppe und einer C₅-C₁₂-Arylgruppe ausgewählt ist; R⁵ eine lineare oder verzweigte C₁₋₃-Alkylenbrücke ist; und R⁷ aus einem C₂- bis C₁₀-Alkyldiradikal ausgewählt ist, das einen dreigliedrigen, viergliedrigen, fünfgliedrigen oder sechsgliedrigen zyklischen Ring mit dem Si-Atom bildet, und wobei m=0, 1 oder 2 und n= 0, 1 oder 2 ist, um eine absorbierte Organosiliziumverbindung auf mindestens einem Abschnitt einer Oberfläche der porösen Schicht mit niedriger Dielektrizitätskonstante (3) bereitzustellen;
c. Spülen des Reaktors mit einem Spülgas;
d. Einführen eines Plasmas in den Reaktor, um mit der absorbierten Organosiliziumverbindung zu reagieren, und
e. Spülen des Reaktors mit einem Spülgas;
wobei die Schritte b bis e wiederholt werden, bis eine gewünschte Dicke der Porenversiegelungsschicht auf der Oberfläche gebildet ist und eine versiegelte Schicht mit Dielektrizitätskonstante bereitstellt und
wobei eine oxidierende Umgebung während der Abscheidung der Porenversiegelungsschicht vermieden wird.

2. Verfahren nach Anspruch 1, wobei R² aus Wasserstoff, Methyl, Ethyl, Propyl und Vinyl ausgewählt ist; R³, wo vorhanden, aus Methyl, Ethyl, Propyl und Vinyl ausgewählt ist; R⁴ aus Methyl, Ethyl, Propyl, Butyl ausgewählt ist; R⁵, wo vorhanden, eine C₁- oder C₂-Alkylenbrücke ist; und R⁷, wo vorhanden, ein C₃- oder C₄-Alkyldiradikal ist, das einen viergliedrigen oder fünfgliedrigen zyklischen Ring mit dem Si-Atom bildet.

3. Verfahren nach Anspruch 1 oder 2, wobei m=0 oder 1 und n=1 oder 2 ist.

4. Verfahren nach einem der Ansprüche 1 bis 3, wobei die mindestens eine Organosiliziumverbindung die Verbindung der Formel A umfasst und aus der Gruppe bestehend aus Trimethoxymethylsilan, Dimethoxydimethylsilan, Triethoxymethylsilan, Diethoxydimethylsilan, Trimethoxysilan, Dimethoxymethylsilan, Diethoxymethylsilan, Dimethoxyvinylmethylsilan, Dimethoxydivinylsilan, Diethoxyvinylmethylsilan, Diethoxydivinylsilan und Diisopropyldimethoxysilan ausgewählt ist.

5. Verfahren nach einem der Ansprüche 1 bis 3, wobei die mindestens eine Organosiliziumverbindung die Verbindung der Formel B umfasst und aus der Gruppe bestehend aus 1,1,3,3-tetramethoxy-1,3-dimethyldisiloxan, 1,1,3,3-tetraethoxy-1,3-dimethyldisiloxan, 1,3-dimethoxy-1,1,3,3-tetramethyldisiloxan und 1,3-diethoxy-1,1,3,3-tetramethyldisiloxan ausgewählt ist.

6. Verfahren nach einem der Ansprüche 1 bis 3, wobei die mindestens eine Organosiliziumverbindung die Verbindung der Formel C umfasst und aus der Gruppe bestehend aus Dimethyldiacetoxysilan und Methyltriacetoxysilan ausgewählt ist.

7. Verfahren nach einem der Ansprüche 1 bis 3, wobei die mindestens eine Organosiliziumverbindung die Verbindung der Formel D umfasst und aus der Gruppe bestehend aus 1,1,3,3-tetraacetoxy-1,3-dimethyldisiloxan und 1,3-tetraacetoxy-1,1,3,3-tetramethyldisiloxan ausgewählt ist.

8. Verfahren nach einem der Ansprüche 1 bis 3, wobei die mindestens eine Organosiliziumverbindung die Verbindung der Formel E umfasst und aus der Gruppe bestehend aus 1-methyl-1-methoxy-1-silacyclopentan, 1-methyl-1-ethoxy-1-silacyclopentan, 1-methyl-1-iso-propoxy-1-silacyclopentan, 1-methyl-1-n-propoxy-1-silacyclopentan, 1-methyl-1-n-butoxy-1-silacyclopentan, 1-methyl-1-sec-butoxy-1-silacyclopentan, 1-methyl-1-iso-butoxy-1-silacyclopentan, 1-methyl-1-tert-butoxy-1-silacyclopentan, 1-methoxy-1-silacyclopentan, 1-ethoxy-1-silacyclopentan, 1-methyl-1-methoxy-1-silacyclobutan, 1-methyl-1-ethoxy-1-silacyclobutan, 1-methoxy-1-silacyclobutan und 1-ethoxy-1-silacyclobutan ausgewählt ist.

9. Verfahren nach einem der Ansprüche 1 bis 3, wobei die mindestens eine Organosiliziumverbindung die Verbindung der Formel F umfasst und aus der Gruppe bestehend aus 1,2-bis(dimethoymethylsilyl)methan, 1,2-bis(diethoymethylsilyl)methan, 1,2-bis(dimethoymethylsilyl)ethan, 1,2-bis(diethoymethylsilyl)ethan und 1,2-bis(trimethoxysilyl)ethan ausgewählt ist.

10. Verfahren nach einem vorhergehenden Anspruch, wobei die Dicke der Porenversiegelungsschicht 5 Nanometer oder weniger, 3 Nanometer oder weniger oder 1 Nanometer oder weniger beträgt.

11. Verfahren nach einem vorhergehenden Anspruch, wobei die poröse Schicht mit niedriger Dielektrizitätskonstante (3) eine erste Dielektrizitätskonstante aufweist und die versiegelte Schicht mit niedriger Dielektrizitätskonstante eine zweite Dielektrizitätskonstante aufweist und eine Differenz zwischen der ersten Dielektrizitätskonstante und der zweiten Dielektrizitätskonstante 0,5 oder weniger, 0,4 oder weniger oder 0,2 oder weniger beträgt.

12. Verfahren nach einem vorhergehenden Anspruch, wobei eine erste Abscheidungsrate der Porenversiegelungsschicht auf der porösen Schicht mit niedriger Dielektrizitätskonstante (3) 2 bis 10 mal größer ist als eine zweite Abscheidungsrate der Porenversiegelungsschicht auf dem Metall.

13. Verfahren nach einem vorhergehenden Anspruch, wobei das Verfahren ein Verfahren zum Bilden einer Porenversieglungsschicht über plasmaverstärkte atomische Schichtablagerung (PEALD), plasmaverstärkte chemische Dampfabscheidung (PECCVD) oder einen plasmaverstärkten ALDartigen Prozess ist und das Verfahren ferner die Schritte umfasst:
f. Einführen mindestens einer Organosiliziumverbindung der Formeln A bis G in den Reaktor, wobei sich die mindestens eine Organosiliziumverbindung, von dem mindestens einen Organosilizium im Verfahrensschritt b unterscheidet;
g. Spülen des Reaktors mit einem Spülgas;
h. Einführen eines Plasmas in den Reaktor, um mit der absorbierten Organosiliziumverbindung zu reagieren; und
i. Spülen des Reaktors mit einem Spülgas;
wobei die Schritte b bis i wiederholt werden, bis eine gewünschte Dicke des Films erreicht ist.

14. Verfahren nach Anspruch 13, wobei die Schritte b bis e für eine bestimmte Anzahl an Zyklen wiederholt werden und dann die Schritte f bis i für eine bestimmte Anzahl an Zyklen wiederholt werden.

## Revendications

1. Procédé de formation d'une couche de scellement de pores, le procédé comprenant les étapes consistant à :
a. disposer un substrat ayant une couche poreuse (3) à faible constante diélectrique et une couche métallique dans un réacteur, le substrat ayant des groupes SiOH exposés contenus dans la couche poreuse (3) à faible constante diélectrique qui restent sur la couche en provenance d'un ou plusieurs des procédés de fabrication suivants : gravure, calcination, planarisation et / ou des combinaisons de ceux-ci ;
b. mettre en contact le substrat avec au moins un composé organosilicié choisi dans le groupe consistant en un composé ayant l'une des Formules A à G suivantes :
| | | |
|---|---|---|
| (R⁴O)₃₋ₘSiR²R³ₘ | (R⁴O)₃₋ₙR²ₙSi-O-SiR²ₙ(OR³)₃₋ₙ | (R⁴COO)₃₋ₘSiR²R³ₘ |
| A | B | C |
| (R⁴COO )₃₋ₙR²ₙSi-O-SiR²ₙ(OOCR⁴)₃₋ₙ | 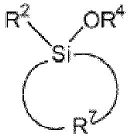 | (R⁴O)₃₋ₙR²ₙSi-R⁵-SiR²ₙ(OR⁴)₃₋ₙ |
| D | E | F |
| (R³R⁴N)₃₋ₙR²ₙSi-O-SiR²ₙ(NR³R⁴)₃₋ₙ | | |
| G | | |
dans lesquelles R² et R³ sont chacun indépendamment choisis dans le groupe consistant en un atome d'hydrogène, un groupe alkyle linéaire en C₁ à C₁₀, un groupe alkyle ramifié en C₃ à C₁₀, un groupe alkyle cyclique en C₃ à C₁₀, un groupe aryle en C₅ à C₁₂, un groupe alcényle linéaire ou ramifié en C₂ à C₁₀ et un groupe alcynyle linéaire ou ramifié en C₂ à C₁₀ ; R⁴ est choisi parmi un groupe alkyle linéaire en C₁ à C₁₀, un groupe alkyle ramifié en C₃ à C₁₀, un groupe alkyle cyclique en C₃ à C₁₀, un groupe alcényle linéaire ou ramifié en C₃ à C₁₀, un groupe alcynyle linéaire ou ramifié en C₃ à C₁₀ et un groupe aryle en C₅ à C₁₂ ; R⁵ est un pont alkylène en C₁₋₃ linéaire ou ramifié ; et R⁷ est choisi parmi un di-radical alkyle en C₂ à C₁₀ qui forme un noyau cyclique à trois chaînons, quatre chaînons, cinq chaînons ou six chaînons avec l'atome de Si et où m = 0, 1 ou 2 et n = 0, 1 ou 2, pour fournir un composé organosilicié absorbé sur au moins une partie d'une surface de la couche poreuse (3) à faible constante diélectrique ;
c. purger le réacteur avec un gaz de purge ;
d. introduire un plasma dans le réacteur pour réagir avec le composé organosilicié absorbé, et
e. purger le réacteur avec un gaz de purge ;
dans lequel les étapes b à e sont répétées jusqu'à ce qu'une épaisseur souhaitée de la couche de scellement de pores soit formée sur la surface et fournisse une couche à constante diélectrique scellée et
dans lequel un environnement oxydant est évité pendant le dépôt de la couche de scellement de pores.

2. Procédé selon la revendication 1, dans lequel R² est choisi parmi hydrogène, méthyle, éthyle, propyle et vinyle ; R³ est, s'il est présent, choisi parmi méthyle, éthyle, propyle et vinyle ; R⁴ est choisi parmi méthyle, éthyle, propyle, butyle ; R⁵ est, s'il est présent, un pont alkylène en C₁ ou C₂ ; et R⁷ est, s'il est présent, un di-radical alkyle en C₃ ou C₄ qui forme un noyau cyclique à quatre chaînons ou cinq chaînons avec l'atome de Si.

3. Procédé selon l'une des revendications 1 ou 2, dans lequel m = 0 ou 1 et n = 1 ou 2.

4. Procédé selon l'une quelconque des revendications 1 à 3, dans lequel ledit au moins un composé organosilicié comprend le composé ayant la Formule A et est choisi dans le groupe consistant en le triméthoxyméthylsilane, le diméthoxydiméthylsilane, le triéthoxyméthylsilane, le diéthoxydiméthylsilane, le triméthoxysilane, le diméthoxyméthylsilane, le diéthoxyméthylsilane, le diméthoxyvinylméthylsilane, le diméthoxydivinylsilane, le diéthoxyvinylméthylsilane, le diéthoxydivinylsilane et le diisopropyldiméthoxysilane.

5. Procédé selon l'une quelconque des revendications 1 à 3, dans lequel ledit au moins un composé organosilicié comprend le composé ayant la Formule B et est choisi dans le groupe consistant en le 1,1,3,3-tétraméthoxy-1,3-diméthyldisiloxane, le 1,1,3,3-tétraéthoxy-1,3-diméthyldisiloxane, le 1,3-diméthoxy-1,1,3,3-tétraméthyldisiloxane et le 1,3-diéthoxy-1,1,3,3-tétraméthyldisiloxane.

6. Procédé selon l'une quelconque des revendications 1 à 3, dans lequel ledit au moins un composé organosilicié comprend le composé ayant la Formule C et est choisi dans le groupe consistant en le diméthyldiacétoxysilane et le méthyltriacétoxysilane.

7. Procédé selon l'une quelconque des revendications 1 à 3, dans lequel ledit au moins un composé organosilicié comprend le composé ayant la Formule D et est choisi dans le groupe consistant en le 1,1,3,3-tétraacétoxy-1,3-diméthyldisiloxane et le 1,3-tétraacétoxy-1,1,3,3-tétraméthyldisiloxane.

8. Procédé selon l'une quelconque des revendications 1 à 3, dans lequel ledit au moins un composé organosilicié comprend le composé ayant la Formule E et est choisi dans le groupe consistant en le 1-méthyl-1-méthoxy-1-silacyclopentane, le 1-méthyl-1-éthoxy-1-silacyclopentane, le 1-méthyl-1-iso-propoxy-1-silacyclopentane, le 1-méthyl-1-n-propoxy-1-silacyclopentane, le 1-méthyl-1-n-butoxy-1-silacyclopentane, le 1-méthyl-1-sec-butoxy-1-silacyclopentane, le 1-méthyl-1-iso-butoxy-1-silacyclopentane, le 1-méthyl-1-tert-butoxy-1-silacyclopentane, le 1-méthoxy-1-silacyclopentane, le 1-éthoxy-1-silacyclopentane, le 1-méthyl-1-méthoxy-1-silacyclobutane, le 1-méthyl-1-éthoxy-1-silacyclobutane, le 1-méthoxy-1-silacyclobutane et le 1-éthoxy-1-silacyclobutane.

9. Procédé selon l'une quelconque des revendications 1 à 3, dans lequel ledit au moins un composé organosilicié comprend le composé ayant la Formule F et est choisi dans le groupe consistant en le 1,2-bis(diméthoxyméthylsilyl)méthane, le 1,2-bis(diéthoxyméthylsilyl)méthane, le 1,2-bis(diméthoxyméthylsilyl)éthane, le 1,2-bis(diéthoxyméthylsilyl)éthane et le 1,2-bis(triméthoxysilyl)éthane.

10. Procédé selon l'une quelconque des revendications précédentes, dans lequel l'épaisseur de la couche de scellement de pores est de 5 nanomètres ou moins, de 3 nanomètres ou moins ou de 1 nanomètre ou moins.

11. Procédé selon l'une quelconque des revendications précédentes, dans lequel la couche poreuse (3) à faible constante diélectrique a une première constante diélectrique et la couche scellée à faible constante diélectrique a une seconde constante diélectrique et une différence entre la première constante diélectrique et la seconde constante diélectrique est de 0,5 ou moins, de 0,4 ou moins ou de 0,2 ou moins.

12. Procédé selon l'une quelconque des revendications précédentes, dans lequel un premier taux de dépôt de la couche de scellement de pores sur la couche poreuse (3) à faible constante diélectrique est de 2 fois plus grand à 10 fois plus grand qu'un second taux de dépôt de la couche de scellement de pores sur le métal.

13. Procédé selon l'une quelconque des revendications précédentes, dans lequel le procédé est un procédé de formation d'une couche de scellement de pores par un procédé de dépôt de couches atomiques assisté par plasma (PEALD), un dépôt chimique en phase vapeur cyclique assisté par plasma (PECCVD) ou un procédé analogue au dépôt de couches atomiques (ALD) assisté par plasma, et le procédé comprend en outre les étapes consistant à :
f. introduire dans le réacteur au moins un composé organosilicié ayant les Formules A à G, ledit au moins un composé organosilicié différant dudit au moins un composé organosilicié de l'étape de procédé b ;
g. purger le réacteur avec un gaz de purge ;
h. introduire un plasma dans le réacteur pour réagir avec le composé organosilicié absorbé ; et
i. purger le réacteur avec un gaz de purge ;
dans lequel les étapes b à i sont répétées jusqu'à ce qu'une épaisseur souhaitée du film soit obtenue.

14. Procédé selon la revendication 13, dans lequel les étapes b à e sont répétées pendant un certain nombre de cycles, puis les étapes f à i sont répétées pendant un certain nombre de cycles.
